Europäisches Patentamt

European Patent Office

Office européen des brevets

(11) Publication number: **0 438 047 A1**

## EUROPEAN PATENT APPLICATION

(21) Application number: 91100005.7

(22) Date of filing: 02.01.91

(51) Int. Cl.5: **H01L 29/784**, H01L 29/60

(30) Priority: 08.01.90 JP 1272/90

(43) Date of publication of application:
24.07.91 Bulletin 91/30

(84) Designated Contracting States:
DE FR GB NL SE

(71) Applicant: SUMITOMO ELECTRIC INDUSTRIES,
LTD.
5-33, Kitahama 4-chome, Chuo-ku
Osaka-shi, Osaka 541(JP)

(72) Inventor: Shiga, Nobuo, c/o Yokohama Works
Sumitomo Electric Industries, Ltd., 1,
Taya-cho
Sakae-ku, Yokohama-shi, Kanagawa(JP)

(74) Representative: Kahler, Kurt
Patentanwalt Dipl.-Ing. Kurt Kahler
Gerberstrasse 3 Postfach 1249
W-8948 Mindelheim(DE)

(54) Microwave fet.

(57) In a dual gate FET of this invention, the number of points (A, B, C) for supplying signals to a first gate electrode (20) and the number of points (A', B', C') for supplying signals to a second gate electrode (30) are set to be optimal values so that a noise index is minimized. A difference in electrical length between each signal supply point of each of the first and second gate electrodes (20, 30) and the corresponding gate input terminals (22, 32) has a negligible magnitude with respect to a quarter wavelength of an input signal applied to the corresponding gate input terminal (22, 32). The dual gate FET has a low-noise arrangement, and a microwave can be applied to either one of the first and second gate electrodes (20, 30), thereby obtaining, e. g., a low-noise mixer. In this case, a separator required upon use of a single gate FET can be omitted, thereby easily arranging a monolithic IC.

Fig. 2

## MICROWAVE FET

### BACKGROUND OF THE INVENTION:

(Field of the Invention)

The present invention relates to a field effect transistor (FET) operated in a microwave band and, more particularly, to a dual gate microwave FET.
(Related background Art)

A conventional known FET of this type has two gate electrodes aligned in a direction of gate length and is formed on a GaAs substrate (IEEE Transaction on Electron Devices, Vol. ED-22, No. 10 (1975), p. 897).

Only a DC wave or a low-frequency wave equivalent to the DC wave is applied to the second gate in a conventional dual gate microwave FET.

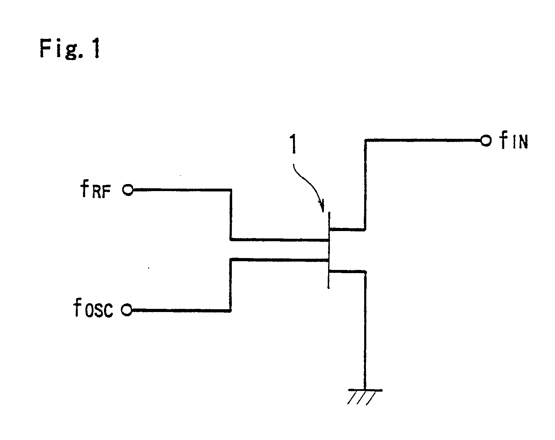

If a microwave can be applied to the second gate, a target conversion signal ($f_{RF}$) is applied to the first gate, and a local oscillation signal ($f_{OSC}$) is applied to the second gate to obtain a desired signal ($f_{IN}$) from the drain, thereby realizing a frequency converter (mixer), as shown in Fig. 1. To the contrary, as a method of realizing a single gate FET having the same function as the above frequency converter, a target conversion signal and a local oscillation signal are applied to the gate electrode. According to this method, however, a separator for separating these two signals from each other is required. In a frequency range exceeding microwaves, this separator is constituted by a transmission circuit. For this reason, a circuit scale is undesirably increased and makes it difficult to provide a monolithic IC (integrated circuit). As another method of realizing a frequency converter by using a single gate FET, a target conversion signal is applied to the gate electrode, and a local oscillation signal is applied to the drain. According to this method, however, a circuit for separating the local oscillation signal from an output signal is required.

In order to realize a frequency converter by using a single gate FET, the circuit for separating the target conversion signal from the local oscillation signal or the local oscillation signal from the output signal is required.

To the contrary, if a dual gate FET can be used to arrange such a frequency converter, the separator is not required. In a conventional dual gate FET, however, the microwave cannot be applied to the second gate, as described above. In addition, a noise level of the dual gate FET is higher than that of the single gate FET.

### SUMMARY OF THE INVENTION:

It is an object of the present invention to provide a dual gate FET suitable for a frequency converter used in a microwave range.

In order to achieve the above object of the present invention, there is provided a dual gate FET wherein the number of points for supplying signal to a first gate electrode and the number of points for supplying signal to a second gate electrode are set to be optimal values so that a noise index is minimized, and a difference in electrical length between an input terminal and the respective signal supply points has a magnitude negligible with respect to a quarter wavelength of a gate input signal.

The FET noise index is known to be reduced when a gate resistance and a gate capacitance are reduced. In a microwave FET having a gate width as large as, e.g., 300 $\mu$m, the gate resistance is reduced when the number of points for supplying a signal to the gate electrode is decreased (theoretically in inverse proportion to the square of the number of signal supply points), but the gate capacitance is increased. There is an optimal signal supply point at which the noise index is minimized in accordance with a balance between the gate resistance an the gate capacitance. The optimal signal supply point value varies depending on the types of material and the structures of FETs, but generally falls within the range of about 3 to 7. According to the present invention, the signal supply points for the first and second gates are optimized to minimize the noise index.

Since an element size in a microwave circuit cannot generally be neglected with respect to a wavelength, the circuit is designed in consideration of the wavelength. That is, in order to apply a microwave signal to the gate electrode and control the gate electrode, a signal applied to the gate input terminal must reach the respective signal supply points in the same phase. If a difference in electrical length between two signal supply points and the second gate input terminal corresponds to a quarter wavelength of an input signal, when the input signal reaches the respective signal supply points, a phase difference of 90$^\circ$ ($\pi$/2) occurs. For example, when a voltage magnitude (absolute value) is zero at one signal supply point, a voltage magnitude is maximum at the other signal supply point. In this manner, states at these signal supply points are inverted from each other. A systematic control effect cannot be obtained as a whole. To the contrary, according to the present invention, the difference in electrical length has a negligible magnitude with respect to the quarter wavelength of the input signal. Therefore, the signal can reach the respective signal supply points in almost the same phase. Therefore, it is possible to effectively utilize a control effect of the second gate electrode in a microwave range. For example, the wavelength of an electrical signal (electromagnetic wave) is shorter on a dielectric substrate such as a GaAs substrate than in a vacuum. In a microstrip line on a GaAs substrate, an X band range (frequency: about 10 GHz) used in, e.g., satellite communication is about 8 to 10 mm. This reduction in wavelength varies depending on a dielectric constant of a substrate and a structure of a transmission line, e.g., a coaxial cable or microstrip line, as a matter of course.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

BRIEF DESCRIPTION OF THE DRAWINGS:

Fig. 1 is a circuit diagram of a frequency converter using a dual gate FET; and
Fig. 2 is a plan view showing an FET according to an embodiment of the present invention.

DETAILED DESCRIPTION OF THE PREFERRED EMBODIMENT:

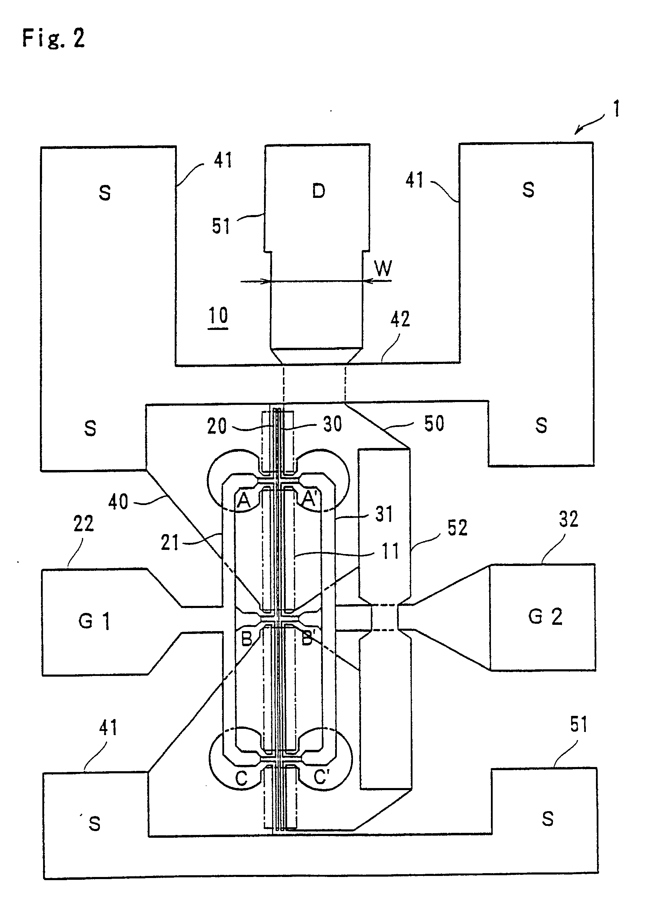

An embodiment of the present invention is now explained with reference to Fig. 2.

Fig. 2 is a plan view showing a structure of an FET 1 according to this embodiment. Electrodes and wiring patterns of the FET are viewed from only the top, and an insulating interlayer and the like are not illustrated. A first gate electrode 20, a second gate electrode 30, a source electrode/wiring layer 40, and a drain electrode/wiring layer 50 are formed on a semi-insulating substrate 10 made of GaAs.

The first gate electrode 20 is connected to a first gate input terminal (pad) 22 through a lead wiring pattern 21 at three signal supply points (A, B, and C). Similarly, the second gate electrode 30 is connected to a second gate input terminal 32 through a lead wiring pattern 31 at three signal supply points (A', B', and C'). The signal supply points of the second gate electrode 30 are symmetrical with those of the first gate electrode 20.

The numbers of signal supply points are selected to be optimal values so that a noise index is minimized.

The second gate input terminal 32, the signal supply points of the second gate electrode 30, and the lead wiring pattern 31 for connecting the second gate input terminal 32 and the signal supply points are arranged so that a difference in electrical length between each signal supply point and the second gate input terminal 32 has a negligible magnitude with respect to one quarter of a wavelength of a second gate input signal. More specifically, the three signal supply points of the second gate electrode 30 in this embodiment are symmetrical about a central line obtained by dividing the second gate electrode 30 into halves at the center in the direction of gate width. The difference in electrical length between the end signal supply point A' and the second gate input terminal 32 is equal to that between the end signal supply point C' and the second gate input terminal 32. The difference in electrical length between the central signal supply point B' and the second gate input terminal 32 is slightly smaller than that between each end signal supply point and the second gate input terminal 32. However, the difference in electrical length between the second gate input terminal 32 and the end and central signal supply points is less than one tenth (about 200 $\mu$m) of less of a quarter wavelength of a 10-GHz signal.

A phase difference caused when a microwave signal applied to the second gate input terminal 32 reaches the respective signal supply points can be neglected. It is, therefore, possible to utilize a microwave as a control signal applied to the second gate electrode 30.

The first and second gate electrodes 20 and 30 form Schottky junctions on an active layer 11 indicated by the alternate long and short dashed line in Fig. 2. The source and drain electrodes are in ohmic contact with $n^+$-type regions formed at both sides of the gate electrodes. The source and drain electrodes can be formed by an underlying wiring layer and are connected to upper terminals 41 and 51 through contact holes. A drain wiring layer 52 intersecting with the lead wiring pattern 31 of the second gate electrode 30 and a source wiring layer 42 intersecting with the drain wiring layer 50 are formed by the upper wiring layer.

The first and second gate and drain terminals (pads) 22, 32, 41, and 51 are arranged to have sizes and pitches (pad size: 70 to 100 $\mu$m; pitch: 150 $\mu$m) so that they are probed by a microwave wafer prober available from CASCADE MICRO TEC Corp. Therefore, measurements for modeling necessary for circuit design can be easily performed. A width W of the lead wiring pattern connected to the drain has a size (about 70 $\mu$m given

when a 100-$\mu$m thick GaAs substrate 10 is used) so that its characteristic impedance is set to be 50 $\Omega$ in consideration of matching with a measuring system.

A low-noise mixer shown in Fig. 1 can be arranged by using the FET 1 of this embodiment.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

**Claims**

1. A microwave FET including first (20) and second (30) gate electrodes aligned in a direction of gate length, and source (40) and drain electrodes (50) formed to interpose said first (20) and second (30) gate electrodes therebetween, wherein said first gate electrode (20) has a plurality of signal supply points (A, B, C) and said second gate electrode (30) has a plurality of signal supply points (A', B', C'), and any difference in electrical length between each of said plurality of signal supply points (A, B, C) of said first gate electrode (20) and a first gate input terminal (22), and any difference in electrical length between each of said plurality of signal supply points (A', B', C') of said second gate electrode (30) and a second gate input terminal (32) is smaller than a quarter wavelength of an input signal applied to each of said first and second gate input terminals (22, 32).

2. An FET according to claim 1, wherein the number of said plurality of signal supply points (A, B, C) of said first gate electrode (20) and the number of said plurality of signal supply points (A', B', C') of said second gate electrode (30) are set to values for minimizing a noise index.

3. An FET according to claim 1 or 2, wherein each of the difference in electrical length between each of said plurality of signal supply points (A, B, C) of said first gate electrode (20) and said first gate input terminal (22) and the difference in electrical length between each of said plurality of signal supply points (A', B', C') of said second gate electrode (30) and said second gate input terminal (32) is set to be not more than one tenth of the quarter wavelength of the input signal applied to each of said first and second gate input terminals (22, 32).

4. An FET according to any of claims 1 to 3, wherein said plurality of signal supply points (A, B, C) of said first gate electrode (20) and said plurality of signal suply points (A', B', C') of said second gate electrode (30) are symmetrical about lines crossing centers of said first and second gate electrodes (20, 30) in a direction of gate length, respectively.

5. An FET according to any of claims 1 to 4, wherein a characteristic impedance of a lead wiring pattern (52) between said drain electrode (50) and said output terminal (51) is set to be a desired value by adjusting a wiring width thereof.

6. A frequency converter comprising: a dual gate microwave FET according to any of the preceding claims said first gate input terminal (22) serving as a target conversion signal input terminal, said second gate input terminal (32) serving as a local oscillation signal input terminal, and a terminal (51) connected to said drain terminal (50) serving as an output terminal.

Fig. 1

Fig. 2

European
Patent Office

EUROPEAN SEARCH
REPORT

Application Number

EP 91 10 0005

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | EP-A-0 189 597 (TEXAS INSTRUMENTS INCORPORATED) <br> * abstract; figure 2 * * page 6, line 25 - page 7, line 1 * <br> — — — | 1-3,5,6 | H 01 L 29/60 <br> H 01 L 29/812 |
| Y | CONFERENCE PROCEEDINGS 4TH EUROPEAN MICROWAVE CONFERENCE TUESDAY 10 TO FRIDAY 13 SEPT. 1974 SEVENOAKS, KENT TN13 1JG ENGLAND pages 87 - 90; CHARLES A. LIECHTI: "CHARACTERISTICS OF DUAL-GATE GaAs MESFETs" <br> * the whole document * <br> — — — | 1-3,5,6 | |
| A | PATENT ABSTRACTS OF JAPAN vol. 7, no. 27 (E-156) 03 February 1983, <br> & JP-A-57 181169 (NIPPON DENKI KK) 08 November 1982, <br> * the whole document * <br> — — — | 1,4 | |
| A | PATENT ABSTRACTS OF JAPAN vol. 11, no. 117 (E-498) 11 April 1987, <br> & JP-A-61 263249 (NEC CORP) 21 November 1986, <br> * the whole document * <br> — — — | 1,2 | |
| A | EP-A-0 081 396 (NATIONAL AERONAUTICS AND SPACE) <br> * abstract; figure 4 * * page 12, lines 1 - 7 * <br> — — — — — | 1 | TECHNICAL FIELDS SEARCHED (Int. Cl.5) <br><br> H 01 L |

The present search report has been drawn up for all claims

| Place of search | Date of completion of search | Examiner |
|---|---|---|
| The Hague | 27 May 91 | MIMOUN B.J. |